# EUROPEAN PATENT APPLICATION

(11) **EP 4 312 248 A1**
(43) Date of publication of application: **31.01.2024**
(21) Application number: 22187125.4
(22) Date of filing: 27.07.2022
(51) Int. Cl.: H01L 21/20

(54) **A HETEROEPITAXIAL WAFER FOR THE DEPOSITION OF GALLIUM NITRIDE**

(71) Applicant: Siltronic AG, 81677 München (DE)
(72) Inventor: Murphy, Brian, 84347 Pfarrkirchen (DE); Thapa, Sarad Bahadur, 84489 Burghausen (DE)

(57) **Abstract**

A heteroepitaxial wafer comprising in the following order (1) a substrate made of Silicon having a thickness, a diameter, a crystal orientation, a resistivity, a frontside and a backside, (2) a nucleation layer comprising AIN and 3C-SiC, (3) a first boron nitride layer having a first boron nitride layer thickness and (4) a layer of nitride having a nitride layer thickness comprising an element out of the list of elements of Aluminum, Gallium, Indium and Thallium.

## Description

The present invention relates to a heteroepitaxial wafer that can be used to deposit Gallium nitride on it.

### Description of the Related Art

Gallium nitride (GaN) offers fundamental advantages over silicon. In particular, the higher break down voltage makes it very attractive for power semiconductor devices with outstanding specific dynamic on-state resistance and smaller capacitances compared to silicon MOSFETs, which makes GaN HEMTs great for high-speed switching. Not only because of the resulting power savings and total system cost reduction, it also allows a higher operating frequency, improves the power density as well as the overall system efficiency.

Group III nitride semiconductors represented by gallium nitride (GaN) have a very broad application prospect because they can also be used in blue light emitting diodes (LEDs), high-density optical storage, high-temperature, high-power and highfrequency electronic devices, ultraviolet detectors, and other fields.

However, due to the lack of homogeneous substrates, it is difficult to obtain high quality GaN films. Most of the device grade GaN films prepared so far are obtained on sapphire substrates. Since sapphire substrates are hard, non-conductive, and expensive, it is difficult to produce large quantities, so people try to grow high quality GaN on silicon substrates, which are inexpensive, thermally conductive, electrically conductive, large in size, easy to solve and easy to integrate with photoelectricity, in order to overcome the shortcomings of sapphire substrates.

However, the lattice mismatch between silicon (Si) and gallium nitride (GaN) reaches 20%, and the thermal mismatch is as high as 56%, which makes the epitaxial growth of gallium nitride (GaN) on silicon substrates very easy to crack.

The Chinese patent application CN 1 05 861 987 A discloses a method to grow a gallium nitride layer on a hexagonal boron nitride transition layer. Silicon can be used as a substrate.

The Japanese patent application JP 2021 020 819 A discloses a method to grow epitaxial 3C-SiC on a crystalline substrate. The Japanese patent application JP 2000 178 740 A discloses a further method of growing epitaxial 3C-SiC on a silicon substrate.

The Chinese patent application CN 1 825 539 A discloses a method to grow a crack-free group III nitride layer on a silicon substrate.

The Chinese patent application CN 1 06 684 139 A discloses a Gallium nitride structure based on a Si substrate, comprising a first AIN buffer layer, a layer slip layer, a second AIN buffer layer, an AlₓGa₁₋ₓN buffer layer, and a GaN epitaxial layer stacked sequentially on the Si substrate; the said AlₓGa₁₋ₓN buffer layer has an Al content x in the range of 0 < x < 1.

The aforementioned patent applications aim to reduce the effects of the lattice mismatch between silicon and Gallium Nitride (or other Group III nitrides).

It is an object of the invention to avoid that the substrate itself negatively influences the function of a Group III nitride device built thereon.

The solution is achieved by the features of the independent claim and its dependent claims of this invention.

### Detailed Description

Although having some technical measures in place which are known in the prior art the inventors realized that the substrate itself still negatively influences the function of a Group III nitride device to some extent.

Therefore, the main motivation is to provide an improved heteroepitaxial wafer for this purpose, in particular a heteroepitaxial wafer that is virtually crack-free and is suitable making high breakdown voltage nitride-based devices.

The given task is solved by a heteroepitaxial wafer that comprises in the given order:
(1) A substrate made of Silicon having a frontside a backside, a thickness, a diameter and a resistivity
(2) a nucleation layer comprising Aluminiumnitride (AIN) and 3C-SiC,
(3) a first boron nitride layer having a first boron nitride layer thickness and
(4) a layer of nitride having a nitride layer thickness comprising an element out of the list of elements Aluminum, Gallium, Indium and Thallium.

Preferably, the crystal orientation of the silicon substrate has a crystal orientation of 1-1-1. Preferably, the diameter of the heteroepitaxial wafer is more than 125 mm, preferably more than 200 mm, and less than 300 mm.

The crystal that is preferably used for the production of the substrate is obtained by means of a float zone process. Such a process is described in the European patent application EP 2 142 686 A1, for example. The dopant of the crystal is preferably Arsenic, red Phosphor or Boron. The most preferred resistivity is not less than 0.5 mOhm cm and not more than 100 mOhm cm.

More preferably, the crystal used was produced by the Czochralski process having a diameter of more than 200 mm, preferably having a nominal diameter of 300 mm. In addition, the interstitial oxygen concentration of such a crystal is less than 2 × 10¹⁷ At/cm³ (*ASTM F121*). The dopant of the crystal is preferably Arsenic, red Phosphor or Boron. The most preferred resistivity of this crystal is not less than 1 mOhm cm and not more than 100 mOhm cm.

The crystal obtained from the crystal growth process is then preferably cut into crystal pieces and then cut into wafers, cleaned and polished.

The cleaning process removes contamination and particles from the wafer surface prior to epitaxial deposition. A standard SC1 clean followed by a SC2 clean is preferred to be used.

Preferably, a layer of boron nitride is deposited on the front side of the substrate. The deposition process can preferably be carried out by means of a gas phase deposition, preferably Metal Organic Chemical Vapor Deposition (MOCVD) is used. A process suitable for this is described in the Chinese patent application CN 1 825 539 A. The boron nitride layer thickness is preferably not less than 1 µm and not more than 10 µm.

Preferably, a layer of nitride having a nitride layer thickness comprising an element out of the list of elements Aluminum (Al), Gallium (Ga), Indium (In) and Thallium (TI) is placed on top of the boron nitride layer. More preferably, said layer comprises Gallium. The thickness of the nitride layer is preferably not less than 1 µm and not more than 10 µm.

The combined thickness (sum of both thicknesses) of the first boron nitride layer and the layer of nitride is not less than 2 µm and not more than 12 µm.

Preferably, a second boron nitride layer having a second boron nitride layer thickness is placed on the backside of the substrate. More Preferably, the thickness of the layer is not less than 50 nm and not more than 10 µm.

The inventors realized that it is particularly advantageous to place a nucleation layer in addition on the front side of the substrate before the first boron nitride layer is added. The nucleation layer, preferably, comprises Aluminum Nitride and 3C-SiC and has a thickness of not less than 50 nm and not more than 500 nm. This nucleation layer has the effect that crystal defects arising from the lattice mismatch between Si and BN can be reduced. Furthermore, the breakdown voltage of III-N devices fabricated on this additional layer is increased.

The inventors further realized that using the combination of the nucleation layer and the boron nitride layer significantly improves the crystal defect quality of the nitride layer.

## Claims

1. A heteroepitaxial wafer comprising in the following order
(1) a substrate made of Silicon having
a thickness,
a diameter, a crystal orientation, a resistivity, a frontside and a backside,
(2) a nucleation layer comprising Aluminium Nitride (AIN) and 3C-SiC,
(3) a first boron nitride layer having a first boron nitride layer thickness and
(4) a layer of nitride having a nitride layer thickness comprising an element out of the list of elements of Aluminum, Gallium, Indium and Thallium.

2. A heteroepitaxial wafer according to claim 1, **characterized in that**
the layer of a nitride comprises Gallium Nitride.

3. A heteroepitaxial wafer according to any of the preceding claims,
**characterized in that**
the diameter is more than 125 mm and not more than 300 mm.

4. A heteroepitaxial wafer according to any of the preceding claims,
**characterized in that**
the diameter is more than 200 mm and not more than 300 mm.

5. A heteroepitaxial wafer according to any of the preceding claims,
**characterized in that**
the resistivity of the substrate is not less than 0.5 mOhm cm and not more than 100 mOhm cm.

6. A heteroepitaxial wafer according to any of the preceding claims,
**characterized in that**
the crystal orientation of the substrate is 1-1-1.

7. A heteroepitaxial wafer according to any of the preceding claims, further comprising
a first nucleation layer having a first nucleation layer thickness that is placed between the substrate and the boron nitride layer.

8. A heteroepitaxial wafer according to claim 7
wherein the first nucleation layer comprises epitaxial AIN and epitaxial SiC.

9. A heteroepitaxial wafer according to any of the preceding claims,
**characterized in that**
the first boron nitride layer thickness is not less than 1 µm and not more than 10 µm.

10. A heteroepitaxial wafer according to any of the preceding claims,
**characterized in that**
the first boron nitride layer thickness is not less than 50 nm and not more than 10 µm.

11. A heteroepitaxial wafer according to any of the preceding claims,
**characterized in that**
the nitride layer thickness is not more than 10 µm and not less than 1 µm.

12. A heteroepitaxial wafer according to any of the preceding claims,
**characterized in that**
the combined thickness of the first boron nitride layer and the layer of nitride is not more than 12 µm and not less than 2 µm.
